# EUROPÄISCHE PATENTANMELDUNG

(11) **EP 4 810 648 A1**
(43) Veröffentlichungstag der Anmeldung: **23.09.2026**
(21) Anmeldenummer: 25165332.5
(22) Anmeldetag: 21.03.2025
(51) Int. Cl.: C23C 14/04, C23C 14/06, C23C 14/22, C23C 14/24, H10N 52/01, H10N 52/85, H10N 60/01

(54) **VERFAHREN UND VORRICHTUNG ZUR HERSTELLUNG VON NANOSTRUKTUREN UND ZUGEHÖRIGE STRUKTUR**

(71) Anmelder: Forschungszentrum Jülich GmbH, 52428 Jülich (DE)
(72) Erfinder: VAßEN-CARL, Max, 52066 Aachen (DE); SCHÜFFELGEN, Peter, 53115 Bonn (DE); GRÜTZMACHER, Detlev, 52382 Niederzier (DE)
(74) Vertreter: Gille Hrabal Partnerschaftsgesellschaft mbB Patentanwälte

(57) **Zusammenfassung**

Offenbart wird ein Verfahren und eine Vorrichtung zur Herstellung einer Nanostruktur durch Materialabscheidung auf einem Substrat (10), bei dem eine Schattenmaske (15) verwendet wird, um mindestens einen Bereich (11) zu begrenzen, an dem Quellmaterial (1, 2, 3, 4) abgeschieden wird. Das Verfahren umfasst ein Abscheiden eines ersten Quellmaterials (1) mittels einer ersten Materialquelle (6), wobei die erste Materialquelle (6) in einer Abscheidungsposition (20) relativ zum Substrat (10) angeordnet ist, ein Durchführen einer Relativbewegung (27) zwischen der ersten Materialquelle (6) und/oder einer zweiten Materialquelle (7) einerseits und dem Substrat (10) andererseits derart, dass die zweite Materialquelle (7) in der Abscheidungsposition (20) relativ zum Substrat (10) angeordnet wird, und ein Abscheiden eines zweiten Quellmaterials (2) mittels der zweiten Materialquelle (7) auf dem abgeschiedenen ersten Quellmaterial (1). Es können somit auch mehrere Quellmaterialien selektiv abgeschieden werden, die mit herkömmlichen Verfahren nicht gemeinsam selektiv gewachsen werden können.

## Beschreibung

Die Erfindung betrifft Verfahren und eine Vorrichtung zur Herstellung einer Struktur sowie eine zugehörige Struktur, insbesondere eine Nanostruktur, durch Materialabscheidung auf einem Substrat. Es wird durch Abscheidung von Quellmaterialien eine neue Phase erzeugt. Insbesondere wird ein neues Material erzeugt, das aus mindestens zwei unterschiedlichen Arten von Atomen aufgebaut ist und deshalb im Folgenden als Verbundmaterial bezeichnet wird. Verbundmaterial im Sinne der Erfindung meint demnach keinen Kompositwerkstoff. Ein Verbundmaterial im Sinne der Erfindung kann Bereiche aus verschiedenen Materialien umfassen, etwa eine Schichtfolge, oder homogen sein.

Zur Herstellung von Nanostrukturen kann zunächst durch Wachsen ein flächiger Film hergestellt werden, der anschließend per Lithografie strukturiert wird. Dadurch wird allerdings die Qualität der Seitenflächen verringert.

Die Publikation WO 2018 171 823 A1 betrifft das selektive Wachstum bzw. Abscheiden von Majorana-Materialien und die Kombination derselben mit Supraleitern. Hierbei wird einerseits eine erste Maske für ein strukturiertes Aufbringen des Majorana-Materials und andererseits eine weitere Maske für das strukturierte Wachstum eines supraleitenden Materials erzeugt und verwendet. Das strukturierte Aufbringen des Majorana-Materials und des supraleitenden Materials erfolgt ohne Unterbrechung in einer inerten Atmosphäre. Selektives oder strukturiertes Wachstum meint Wachstum nur an bestimmten Stellen.

Dieses Verfahren hat jedoch den Nachteil, dass es nicht für alle Quellmaterialien bzw. Quellmaterialkombinationen verwendet werden kann. Beispielsweise ist die Legierung und/oder Dotierung von topologischen Isolatoren, z. B. mit (magnetischen) Übergangsmetallen, mit dem beschriebenen Verfahren nicht möglich, da aufgrund des hohen Haftungskoeffizienten der Übergangsmetalle kein selektives Wachstum bzw. Abscheiden der Legierung auf dem Substrat möglich ist. Auch die Verbindung mehrerer Quellmaterialien ist nur möglich, wenn die unter den jeweiligen Bedingungen einschlägigen Abscheidetemperaturen dieser Quellmaterialien in einem ähnlichen Bereich liegen.

Es ist die Aufgabe der Erfindung, ein verbessertes Verfahren zur Herstellung von Strukturen, eine verbesserte Vorrichtung sowie eine verbesserte Struktur zur Verfügung zu stellen. Insbesondere soll eine selektive Abscheidung und/oder ein selektives Wachstum auch für Quellmaterialien ermöglicht werden, bei denen dies bisher bislang nicht möglich war.

Die Aufgabe wird gelöst durch das Verfahren gemäß Anspruch 1 sowie die Vorrichtung und die Struktur gemäß den nebengeordneten Ansprüchen. Vorteilhafte Ausgestaltungen sind in den Unteransprüchen angegeben.

Zur Lösung der Aufgabe dient ein Verfahren zur Herstellung einer Struktur durch Abscheidung von Quellmaterial auf einem Substrat, wobei eine Schattenmaske verwendet wird, um mindestens einen Bereich zu begrenzen, an dem Quellmaterial abgeschieden wird. Das Verfahren umfasst Abscheiden eines ersten Quellmaterials mittels einer ersten Materialquelle, während die erste Materialquelle in einer Abscheidungsposition relativ zum Substrat angeordnet ist. Das Verfahren umfasst insbesondere ferner ein Durchführen einer Relativbewegung zwischen der ersten Materialquelle und/oder einer zweiten Materialquelle einerseits und dem Substrat andererseits. Die Relativbewegung erfolgt insbesondere derart, dass die zweite Materialquelle in einer Abscheidungsposition relativ zum Substrat angeordnet wird. Das Verfahren umfasst insbesondere ferner ein Abscheiden eines zweiten Quellmaterials mittels der zweiten Materialquelle, bevorzugt auf dem abgeschiedenen ersten Quellmaterial.

Auf diese Weise wird ein selektives Wachstum für Quellmaterialien ermöglicht, insbesondere innerhalb eines z. B. durch die Maske geometrisch definierten Bereichs, bei denen das mit herkömmlichen Verfahren nicht möglich war. Es ist nicht nötig, Quellmaterialien zu wählen, die bei einer bestimmten Abscheidetemperatur selektiv auf dem Substrat, nicht jedoch auf einer Maske abgeschieden werden. Es wird keine für ein derartiges selektives Wachstum vorgesehene Maske benötigt. Im Falle von mehreren Quellmaterialien sind die Quellmaterialien insbesondere unterschiedliche Materialien. In einigen Ausführungsformen können aber auch zwei Quellmaterialien dasselbe Material sein. Es kann grundsätzlich jedes Material verwendet werden, das auf geeignete Weise in eine Gasphase überführt oder verdampft und anschließend abgeschieden werden kann. Zudem ist es möglich, zwei oder mehr unterschiedliche Materialien zu kombinieren.

In der Regel liegt das abgeschiedene Quellmaterial in amorpher Form vor. Deshalb findet typischerweise kein Wachstum statt, wie es bei Kristallen der Fall wäre, sondern es erfolgt eine Abscheidung. In einigen Fällen wächst jedoch auch eine kristalline Struktur. Dies ist mit umfasst, da auch in dem Fall das Quellmaterial abgeschieden wird.

Bei herkömmlichen Verfahren werden die verschiedenen Quellmaterialien aufgrund der unterschiedlichen Positionen der Materialquellen und der damit verbundenen unterschiedlichen Winkel, in denen das jeweilige Quellmaterial durch die Maske und auf das Substrat bewegt wird, an unterschiedlichen Positionen abgeschieden. Die Ränder der erzeugten Struktur sind damit nicht scharf begrenzt. Das erfindungsgemäße Verfahren erlaubt dagegen die Herstellung einer scharf begrenzten Struktur. Durch die bevorzugte Bewegung zwischen den Abscheidevorgängen liegen alle abgeschiedenen Quellmaterialien exakt übereinander.

Insbesondere wird eine Anlage verwendet, die es erlaubt, verschiedene Quellmaterialien individuell zu verdampfen, beispielsweise eine Anlage zur Molekularstrahlepitaxie oder TLE (Thermal Laser Epitaxie). Die Anlage kann mehrere Zellen umfassen, die als Materialquelle für die unterschiedlichen Quellmaterialien dienen. Die Anlage umfasst typischerweise eine Kammer, in der die Struktur hergestellt werden kann bzw. innerhalb derer die Abscheidung erfolgt. Eine Materialquelle setzt Quellmaterial frei, insbesondere gasförmiges Quellmaterial, welches nach der Bewegung, insbesondere im gasförmigen Zustand, an der Oberfläche des Substrats angelagert wird bzw. wächst, insbesondere in fester Form. Dies wird als Abscheidung bezeichnet. Die Bewegung von der Quelle zu der Abscheideposition kann als ballistische Bewegung bezeichnet werden. Das Quellmaterial kann z. B. ein elementares Material sein, insbesondere ein Metall, oder eine Legierung.

Die Schattenmaske (engl.: stencil mask) ist ein insbesondere flächiges Element mit typischerweise wenigstens einer Aussparung, insbesondere Öffnung, auch Fenster genannt. Die Aussparung ist durchgehend, so dass Quellmaterial die Schattenmaske passieren kann, um abgeschieden zu werden. Alternativ oder ergänzend kann auch ein Rand der Schattenmaske die Fläche, auf der Material abgeschieden wird, begrenzen Insbesondere wirkt die Maske durch Schattenwurf. Mit anderen Worten wird die Bewegung des Quellmaterials durch die Aussparungsbereiche und/oder an den Rändern vorbei ermöglicht, während die Bewegung des ersten Quellmaterials in den nicht ausgesparten Bereichen blockiert wird. Eine Aussparung kann am Rand der Schattenmaske sein. Eine Öffnung ist dagegen im Inneren, also eingerahmt von dem Material der Schattenmaske. Die Schattenmaske wird insbesondere durch Ätzen strukturiert. Mit anderen Worten werden Aussparungen und/oder Öffnungen durch Ätzen erzeugt. Mehrere benachbarte Bereiche von Schattenmasken können zusammenwirken und zwischen einander einen Freiraum lassen, der wie eine Öffnung wirkt. Zusammenwirkende Schattenmasken können auf unterschiedlichen Ebenen liegen, also unterschiedliche Abstände zum Substrat aufweisen. Die Schattenmaske ist insbesondere temperaturbeständig bis mindestens 500 °C, insbesondere bis mindestens 800 °C, bevorzugt bis mindestens 1000 °C, besonders bevorzugt bis 1200 °C.

Die Abscheidungsposition ist eine Position, von der aus Quellmaterial insbesondere über einen geradlinigen Weg von der Materialquelle durch die Schattenmaske auf den Bereich des Substrats bewegt werden kann. Die Abscheidungsposition der zweiten Materialquelle kann, muss aber nicht notwendigerweise die Abscheidungsposition der ersten Materialquelle sein. Beispielsweise kann die zweite Materialquelle vor die erste Materialquelle bewegt werden und/oder die erste Materialquelle kann aus einer Position zwischen dem Bereich und der zweiten Materialquelle wegbewegt werden. Alternativ können sowohl die erste Materialquelle als auch die zweite Materialquelle bewegt werden, um die erste Materialquelle aus der Abscheidungsposition wegzubewegen und die zweiten Materialquelle in die Abscheidungsposition zu bewegen. Insbesondere entspricht eine Ausrichtung einer ersten Gerade zwischen dem Bereich des Substrats und der Abscheidungsposition der ersten Materialquelle einer Ausrichtung einer zweiten Gerade zwischen dem Bereich des Substrats und der Abscheidungsposition der zweiten Materialquelle. Dies gilt insbesondere analog für alle ggf. vorhandenen zusätzlichen und/oder weiteren Materialquellen.

Typischerweise erfolgt als Relativbewegung eine Bewegung des Substrats. In einem Beispiel wird die erste Materialquelle von der Abscheidungsposition wegbewegt und die zweite Materialquelle wird zu der Abscheidungsposition hinbewegt. Es kann demnach eine Relativbewegung zwischen der ersten Materialquelle und dem Substrat derart erfolgen, dass die erste Materialquelle von der Abscheidungsposition zum Substrat wegbewegt wird. Die jeweilige Bewegung ist eine Relativbewegung. Es ist unerheblich, ob die jeweilige Materialquelle, das Substrat oder beide bewegt werden. Die Relativbewegung dient der Ausrichtung der jeweiligen Materialquelle auf den Bereich durch die Schattenmaske hindurch. Beispielsweise wird die Schattenmaske nacheinander auf jede der benötigten Materialquellen ausgerichtet. Bei der Molekularstrahlepitaxie sind typischerweise die eine oder mehreren Materialquellen ortsfest und das Substrat wird gedreht. Bei der thermischen Laserepitaxie das Substrat fest sein und die Materialquelle oder Materialquellen können bewegt werden. Das Substrat kann aber ebenfalls bewegt werden.

Insbesondere können so in einem Arbeitsgang mehrerer Quellmaterialien abgeschieden werden. In einem Arbeitsgang meint insbesondere ohne Unterbrechung und/oder in einer Aufspannung. Dies wird auch als in-situ bezeichnet. Die erfindungsgemäßen Verfahren sind demnach insbesondere In-Situ-Verfahren. Beispielsweise kann die Abscheidung mehrerer Quellmaterialien in einer zumindest weitgehend konstanten Atmosphäre erfolgen. Eine Atmosphäre im Sinne der Erfindung kann beispielsweise eine Inertgasatmosphäre oder eine evakuierte Atmosphäre sein.

Das Verfahren dient insbesondere der Herstellung einer Mikrostruktur oder einer Nanostruktur, beispielsweise eines Bauteils mit einer Erstreckung und/oder zumindest einem Formelement im Mikrometer-Bereich bzw. im Nanometer-Bereich. Das Verfahren kann dazu verwendet werden, eine neue Phase aus einem oder mehreren Quellmaterialien herzustellen. Beispielsweise kann aus mehreren unterschiedlichen Quellmaterialien ein gewünschtes Verbundmaterial hergestellt werden. Das Verfahren kann beispielsweise zur Herstellung einer dotierten und/oder legierten Struktur verwendet werden. Die Struktur kann Bereiche enthalten, an denen Material vorhanden ist und Bereiche, an denen kein Material vorhanden ist.

In einer Ausführungsform ist das Substrat ein Nichtleiter oder ein Halbleiter. Insbesondere ist das Substrat bei tiefen Temperaturen ein Nichtleiter oder ein Halbleiter, beispielsweise bei Supraleiter-Anwendungen. Auf diese Weise können Transportexperimente durchgeführt werden, ohne dass Strom durch das Substrat fließen könnte. Beispielsweise ist das Substrat Silicium, GaAs, CdTe oder Saphir. Das Substrat hat insbesondere eine zu der herzustellenden Struktur passende Kristallstruktur. In einer anderen Ausführungsform ist das Substrat ein elektrisch leitfähiges und/oder niederohmiges Substrat. Dies ist beispielswiese für STM-Anwendungen (Scanning Tunneling Microscope - Rastertunnelmikroskop) vorteilhaft. In einer Ausführungsform wird mit dem Verfahren ein supraleitendes Material auf ein topologisches Material, insbesondere ein Majorana-Material, aufgetragen. Ein supraleitendes Material kann als Kontakt verwendet werden. In einem Beispiel wird ein nematischer Supraleiter und/oder ein Supraleiter umfassend oder bestehend aus NbTe₂ hergestellt.

Insbesondere erfolgt das Abscheiden des ersten Quellmaterials und das Abscheiden des zweiten Quellmaterials, Teile des Verfahrens oder das gesamte Verfahren in einem Vakuum, beispielsweise ein Ultrahochvakuum (p ≤ 1 × 10⁻⁷ mbar, vorzugsweise p ≤ 1 × 10⁻¹¹ mbar), und/oder in einer inerten Atmosphäre. Insbesondere werden Schritte des Verfahrens, beispielsweise alle Schritte, durchgeführt, ohne das Vakuum bzw. die inerte Atmosphäre zu unterbrechen. Als eine inerte Atmosphäre wird beispielsweise reines N₂ oder Argon angesehen.

In einer Variante umfasst das Verfahren ferner das Bilden einer kristalline Struktur, welche zumindest einen Teil des abgeschiedenen ersten Quellmaterials und/oder zumindest einen Teil des abgeschiedenen zweiten Quellmaterials umfasst. Es wird also eine Kristallstruktur gebildet. Diese kann das erste Quellmaterial, das zweite Quellmaterial oder beide Quellmaterialien umfassen. Die Struktur kann beispielsweise gebildet werden durch Temperaturerhöhung, wie unten beschrieben, oder durch ein Abscheiden bei solchen Temperaturen, dass es zur Selbstepitaxie (engl.: "self-epitaxy") kommt, also zu einer spontanen Umwandlung bzw. Anordnung von Atomen der abgeschiedenen Quellmaterialien, bei der die Struktur entsteht. Auf diese Weise können z. B. elementare, kristalline topologische oder supraleitende Materialien hergestellt werden, wie etwa dünnes Bismut, z. B. 0,2 nm bis 4 nm dick, z. B. unter oder auf einer Schicht aus einem anderen Material wie z. B. Niob. Grundsätzlich kann auch eine Struktur aus oder mit zwei separaten, kristallinen Materialien oder Phasen hergestellt werden. Das Bilden der Kristallstruktur kann grundsätzlich während des Abscheidens erfolgen. Hierzu kann die Abscheidungstemperatur so eingestellt werden, dass direkt beim Abscheiden die kristalline Struktur entsteht.

In einer Variante umfasst das Verfahren ferner das Bilden einer Struktur, welche zumindest einen Teil des abgeschiedenen ersten Quellmaterials und zumindest einen Teil des abgeschiedenen zweiten Quellmaterials umfasst. Die Struktur kann eine kristalline Struktur sein. Die Struktur kann beispielsweise gebildet werden durch Temperaturerhöhung, wie unten beschrieben, oder durch ein Abscheiden bei solchen Temperaturen, dass es zur Selbstepitaxie (engl.: "self-epitaxy") kommt, also zu einer spontanen Umwandlung, Vermischung bzw. Anordnung von Atomen der abgeschiedenen Quellmaterialien, bei der die Struktur entsteht. Auf diese Weise kann z. B. ein amorpher oder kristalliner topologischer Isolator hergestellt werden. Das Bilden der Struktur kann grundsätzlich während des Abscheidens erfolgen. Hierzu kann die Abscheidungstemperatur so eingestellt werden, dass direkt beim Abscheiden die Struktur entsteht.

In einer Ausgestaltung wird eine magnetische Phase oder ein magnetisches Verbundmaterial hergestellt, insbesondere ein magnetischer topologischer Isolator.

Es kann eine magnetische Struktur hergestellt werden. Es kann eine Struktur aus oder mit mehreren Bereichen hergestellt werden, von denen zumindest einer magnetische Eigenschaften aufweist. Ein magnetischer topologischer Isolator kann beispielsweise CrBiSbTe umfassen oder daraus hergestellt sein, beispielsweise (Cr_{y}BiₓSb₁₋ₓ)₂Te₃. Es kann ein Josephson-Kontakt hergestellt werden, etwa umfassend das genannte Material, ggf. in Kombination mit supraleitenden Kontakten.

In einer Ausgestaltung umfasst das Verfahren ferner ein Durchführen einer Relativbewegung zwischen der zweiten Materialquelle und/oder einer dritten Materialquelle einerseits und dem Substrat andererseits. Dies erfolgt insbesondere derart, dass die dritte Materialquelle an einer Abscheidungsposition relativ zum Substrat angeordnet wird. Das Verfahren kann ferner umfassen ein Abscheiden eines dritten Quellmaterials mittels der dritten Materialquelle, insbesondere auf dem abgeschiedenen zweiten Quellmaterial und/oder auf einem hergestellten Verbundmaterial.

In einer Ausgestaltung umfasst das Verfahren ferner ein Durchführen einer Relativbewegung zwischen der dritten Materialquelle und/oder einer vierten Materialquelle einerseits und dem Substrat andererseits. Dies erfolgt insbesondere derart, dass die vierte Materialquelle an einer Abscheidungsposition relativ zum Substrat angeordnet wird. Das Verfahren kann ferner umfassen ein Abscheiden eines vierten Quellmaterials mittels der vierten Materialquelle, insbesondere auf dem abgeschiedenen dritten Quellmaterial und/oder auf einem hergestellten Verbundmaterial. Das für die erste und zweite Materialquelle Gesagte kann ebenso für die dritte und vierte Materialquelle gelten. Es können beliebig viele zusätzliche oder weitere Materialquellen vorhanden sein. So kann eine fünfte, ggf. sechste, ggf. siebte, ggf. achte, ggf. neunte und ggf. eine zehnte Materialquelle vorhanden sein. Für jede dieser Materialquellen kann das oben Genannte analog gelten. Jede dieser Materialquellen kann dazu dienen, einen oder mehrere der beschriebenen Verfahrensschritte auszuführen.

Es kann nach der Abscheidung eines ersten Materials und eines zweiten Materials eine Temperaturerhöhung erfolgen, um die Struktur, insbesondere eine kristalline Struktur, herzustellen. Dies ist weiter unten im Detail beschrieben. Es kann nach der Temperaturerhöhung ein drittes und ggf. viertes Material abgeschieden werden. Es kann alternativ nach der Temperaturerhöhung erneut das erste und/oder zweite Material abgeschieden werden. Es können mehrere Wiederholungen erfolgen, bei denen bestimmte Materialien in einer bestimmten Reihenfolge abgeschieden werden, ggf. mit einer oder mehreren dazwischen geschalteten Temperaturerhöhungen. Beliebige Kombinationen sind möglich.

In einer Ausführungsform wird nach Abscheidung mehrerer Quellmaterialien aus den abgeschiedenen Quellmaterialien ein Verbundmaterial hergestellt. Das Verbundmaterial kann ein magnetisches Verbundmaterial sein. Das Verbundmaterial kann z. B. ein funktionales Material sein, welches supraleitend, magnetisch, topologisch und/oder dielektrisch sein kann. In einer Ausführungsform wird mit dem Verfahren ein supraleitendes Material auf ein topologisches Material, insbesondere ein Majorana-Material, aufgetragen. Ein supraleitendes Material kann als Kontakt verwendet werden.

In einer Ausgestaltung wird nach Abscheidung zumindest zweier und insbesondere aller Quellmaterialien die Temperatur der abgeschiedenen Materialien erhöht, beispielsweise durch Erhöhung der Temperatur des Substrats. So kann ein Verbundmaterial oder eine Struktur, insbesondere ein Kristall, entstehen. Insbesondere wird aus amorphen Schichten der abgeschiedenen Quellmaterialien durch Temperaturerhöhung, auch als "Annealing" bezeichnet, ein Kristall hergestellt. Vorteilhaft wird zur Stabilisierung während der Kristallbildung ein Atom- oder Molekularstrahl genutzt, insbesondere von einem Element, welches im Kristall vorkommt, bevorzugt das flüchtigste der dort vorkommenden Elemente.

Insbesondere wird die Temperatur des Substrats erhöht. Die Erhöhung der Temperatur erfolgt insbesondere durch Erhöhung der Temperatur eines Heizelementes, in dessen Nähe sich die abgeschiedenen Materialien und/oder das Substrat befindet.

In einem Beispiel erfolgt nach einer Abscheidung mindestens zweier Quellmaterialien die Erhöhung der Temperatur und anschließend die Abscheidung mindestens eines, insbesondere zweier Quellmaterialien. Es kann sich dabei um eines oder beide der zwei zu Anfang abgeschiedenen Quellmaterialien handeln oder um ein oder zwei andere Quellmaterialien. Insbesondere werden dieselben Quellmaterialien abgeschieden. Insbesondere erfolgt eine erneute Erhöhung der Temperatur. die Schritte aus erneuter Abscheidung und erneuter Temperaturerhöhung können zweimal oder häufiger wiederholt werden, um eine Schicht der gewünschten Dicke zu erhalten.

Bei herkömmlichen Verfahren werden flächige Dünnfilme des Verbundmaterials hergestellt, anschließend erfolgt die das Herstellen einer Struktur (z. B. durch Stanzen bzw. Ätzen) außerhalb des Vakuums. Dabei gelangen Fremdatome wie O₂ an das Material und lagern sich ein. Es kommt z. B. zur Oxidation. Erfindungsgemäß kann nun die benötigte Form und Größe direkt abgeschieden werden und ggf. direkt im Anschluss das Annealing erfolgen. Insbesondere kann eine Passivierung der hergestellten Phase, z. B. des Verbundmaterials, erfolgen. Fremdatome können so nicht in Kontakt mit der Phase kommen, da sämtliche Schritte im Vakuum bzw. in einer inerten Umgebung durchgeführt werden können.

In einer Ausführungsform werden das erste Quellmaterial und zumindest ein zweites Quellmaterial derart kombiniert, beispielsweise durch chemische Reaktion, dass eine Struktur aus einem gewünschten Verbundmaterial entsteht.

In einer Ausgestaltung wird nach der Abscheidung ein zusätzliches Quellmaterial unter Verwendung der Schattenmaske abgeschieden. Beispielsweise kann ein strukturierter (eine Struktur aufweisender) Normalleiter oder Supraleiter aufgetragen werden, etwa für Elektroden bzw. Kontakte. Die Abscheidung des zusätzlichen Quellmaterials erfolgt insbesondere nach Beendigung der Abscheidungen der ersten, zweiten, ggf. dritten und ggf. vierten und ggf. weiteren Quellmaterialien. So wird auf die hergestellte Struktur eine weitere Struktur aufgebracht.

In einer Ausführungsform wird zunächst eine Phase hergestellt, auf welche die Temperaturerhöhung keinen Einfluss hat, z. B. durch Abscheiden von Quellmaterial. Anschließend werden mehrere Quellmaterialien wie beschrieben abgeschieden und es erfolgt die Temperaturerhöhung. Dadurch wird auf der ersten Phase, welche unverändert bleibt, eine gewünschte zweite Phase, z. B. ein Kristall, aus den mehreren Quellmaterialien erzeugt.

In einer Ausgestaltung sind die Materialquellen in einem Kreisbogen oder Kreis angeordnet. Insbesondere werden die Materialquellen von einem gemeinsamen Bauteil gehalten. Es kann zur Durchführung der Relativbewegung dann eine Drehung des Bauteils oder des Substrats erfolgen, um die jeweilige Materialquelle in der Abscheidungsposition relativ zum Substrat anzuordnen. Die Drehung kann um eine Gerade, die durch den Mittelpunkt des Kreises oder Kreisbogens und ggf. durch das Substrat verläuft, erfolgen. Bei der Anordnung im Kreis oder Kreisbogen ist eine Schattenmaske ausreichend.

Alternativ zur Ausgestaltung in einem Kreis oder Kreisbogen können die Materialquellen grundsätzlich beliebig angeordnet sein. In diesem Fall wird für jede zusätzliche Materialquelle, z. B. die zweite Materialquelle, insbesondere eine weitere Schattenmaske verwendet, die die entsprechend zusätzliche Materialquelle auf dieselbe Stelle abbildet, auf welche die erste Schattenmaske die erste Materialquelle abbildet.

In einer Ausführungsform erfolgt die Relativbewegung, nachdem eine Lage des jeweiligen Quellmaterials abgeschieden wurde. Es kann sich um eine Monolage handeln, bei der einzelne Teilchen wie Atome oder Moleküle in einer Schicht nebeneinander vorliegen. Hierbei entspricht die Schichtdicke dem Durchmesser eines Teilchens. Alternativ oder ergänzend kann die Lage wenige Atomlagen umfassen und/oder dünner sein als ein nm.

In einer Ausgestaltung wird ferner eine weitere Maske verwendet, um mindestens den Bereich zu begrenzen, an dem Quellmaterial abgeschieden wird. In einer Ausgestaltung umfasst das Verfahren ferner ein Bewegen eines weiteren Quellmaterials mittels einer weiteren Materialquelle zu dem Bereich mittels der weiteren Maske und/oder Abscheiden des weiteren Quellmaterials in dem Bereich. Insbesondere ist die weitere Materialquelle in einer von der Abscheidungsposition abweichenden zweiten Position relativ zum Substrat angeordnet. Auf diese Weise kann ein selektives Wachstum erfolgen. Die weitere Maske kann einerseits eine strukturgebende Funktion haben und andererseits der selektiven Abscheidung dienen. Die weitere Maske kann eine weitere Schattenmaske sein oder eine anders geartete Maske, etwa für ein selektives Wachstum.

Das weitere Quellmaterial kann vor, während und/oder nach der Abscheidung des ersten und/oder zweiten Quellmaterials abgeschieden werden. Es kann so beispielsweise nach der Herstellung eines Kristalls und ggf. nach der Erhöhung der Temperatur zur Herstellung eines Verbundmaterials eine weitere Struktur im selben Arbeitsgang hergestellt werden. Die weitere Struktur kann beispielsweise einen oder mehrere Kontakte, beispielsweise mit normalleitendem Material, supraleitendem Material und/oder magnetischem Material, und/oder eine Abdeckung, beispielsweise mit oder aus Al₂O₃ umfassen.

In einer Ausgestaltung wird das zweite oder weitere Quellmaterial unter Verwendung der weiteren Maske unter definierten Abscheidebedingungen selektiv abgeschieden. Dies kann durch Co-Evaporation erfolgen. Bei der Co-Evaporation kann eine kristalline Struktur direkt während des Abscheidens erfolgen. Es handelt sich dann um ein Wachstum.

Beispielsweise wird die Temperatur so eingestellt, dass eine Abscheidung des zweiten Quellmaterials auf dem Substrat erfolgt, aber keine Abscheidung auf der weiteren Maske erfolgt. Beispielsweise wird eine Temperatur oberhalb einer Grenztemperatur eingestellt, so dass keine Abscheidung auf der weiteren Maske erfolgt. Unterhalb der Grenztemperatur würde demnach auch auf der Maske eine Abscheidung erfolgen.

Das zweite Quellmaterial ist demnach insbesondere ein Quellmaterial, das unter bestimmten Abscheidebedingungen am selektiven Wachstum teilnehmen kann. Das erste Quellmaterial ist dahingehend nicht beschränkt und kann hingegen ein beliebiges Material sein, welches auf geeignete Weise in eine Gasphase überführt oder verdampft und anschließend abgeschieden werden kann, insbesondere unter Verwendung einer Anlage zur Molekularstrahlepitaxie.

Das selektive Abscheidung erfolgt insbesondere wie in Druckschrift WO 2018 171 823 A1 mittels der dort als "erste Maske 2, 3" bezeichneten Maske, die der weiteren Maske der vorliegenden Erfindung entspricht. Die Öffnung für das nicht selektiv wachsbare Material kann dabei, wie etwa in Figur 3 der genannten Druckschrift dargestellt, in die obere Maske integriert werden. Alternativ kann die Öffnung in eine zusätzliche, dritte maskierende Schicht integriert sein.

In einem Ausführungsbeispiel sind die weitere Maske und die Schattenmaske so ausgestaltet und angeordnet, dass sie Abscheidung der jeweiligen Quellmaterialien auf deckungsgleichen Bereichen ermöglichen. In einem Ausführungsbeispiel sind die weitere Maske und/oder eine oder mehrere Schattenmasken so ausgestaltet und angeordnet, dass sie Abscheidung der jeweiligen Quellmaterialien auf nicht deckungsgleichen Bereichen ermöglichen. Beispielsweise kann nur ein Bereich einer hergestellten Struktur dotiert werden, wie etwa die Spitze eines Nanodrahtes. Eine Öffnung in der oberen Maske oder Schattenmaske kann dafür nur eine Teilfläche der Öffnung in der unteren Maske oder weiteren Maske darstellen. Es können mehrere Öffnungen genutzt werden, um gleichzeitig verschiedene Bereiche mit verschiedenen Quellmaterialien zu dotieren.

In einer Ausgestaltung werden mehrere unterschiedliche zweite Quellmaterialien oder zweite, dritte und ggf. vierte, etc. Quellmaterialien zeitgleich durch die weitere Maske abgeschieden.

Es können, wie in herkömmlichen Verfahren, mehrere unterschiedliche Quellmaterialien abgeschieden werden, deren Abscheidetemperaturen ausreichend ähnlich sind. Das erste Quellmaterial kann beispielsweise ein Quellmaterial sein, dessen Abscheidetemperatur außerhalb des notwendigen Ähnlichkeitsbereich ist. Dieses Quellmaterial könnte mit herkömmlichen Techniken nicht am selektiven Wachstum teilnehmen.

Wie die Schattenmaske ist auch die weitere Maske ein insbesondere flächiges Element mit typischerweise wenigstens einer Aussparung, insbesondere Öffnung, auch Fenster genannt. Die Aussparung ist durchgehend, so dass das weitere Quellmaterial die weitere Maske passieren kann, um abgeschieden zu werden. Alternativ oder ergänzend kann auch ein Rand der weiteren Maske die Fläche, auf der Material abgeschieden wird, begrenzen. Insbesondere wirkt die Maske durch Abschirmung. Mit anderen Worten wird die Bewegung des weiteren Quellmaterials durch die Aussparungsbereiche und/oder an den Rändern vorbei ermöglicht, während die Bewegung des weiteren Quellmaterials in den nicht ausgesparten Bereichen blockiert und/oder resorbiert wird. Eine Aussparung kann am Rand der weiteren Maske sein. Eine Öffnung ist dagegen im Inneren, also eingerahmt von dem Material der weiteren Maske. Die weitere Maske ist insbesondere direkt auf dem Substrat oder nah am Substrat angeordnet. Die weitere Maske wird insbesondere durch Ätzen strukturiert. Mit anderen Worten werden Aussparungen und/oder Öffnungen durch Ätzen erzeugt. Mehrere benachbarte Bereiche von weiteren Masken können zusammenwirken und zwischen einander einen Freiraum lassen, der wie eine Öffnung wirkt. Das Bewegen des weiteren Quellmaterials zu dem Bereich unter Verwendung der weiteren Maske kann demnach eine Bewegung durch die weiteren Maske, insbesondere durch eine Öffnung oder Aussparung in der weiteren Maske, und/oder eine Bewegung an einem Rand einer oder mehrerer weiterer Masken vorbei sein. Das weitere Quellmaterial ist insbesondere ein Material, welches am selektiven Wachstum partizipieren kann.

Die weitere Maske kann zwei Schichten umfassen. Eine erste Schicht kann direkt auf dem Substrat aufliegen. Die erste Schicht kann zum Beispiel SiO₂ umfassen oder daraus bestehen. Die erste Schicht kann eine Dicke von mindestens 1 nm, bevorzugt mindestens 3 nm, und/oder höchstens 20 nm, bevorzugt höchstens 10 nm aufweisen. Die erste Schicht kann zum Stützen einer zweiten Schicht dienen. Die zweite Schicht kann auf der ersten Schicht aufliegen. Die zweite Schicht kann zum Beispiel Si₃N₄ umfassen oder daraus bestehen. Die zweite Schicht kann dazu dienen, eine selektive Abscheidung von Material zu ermöglichen. Die zweite Schicht kann eine Dicke von mindestens 10 nm, insbesondere mindestens 20 nm, und/oder höchstens 50 nm, insbesondere höchstens 30 nm aufweisen. Insbesondere ist die erste Schicht dicker als die zweite Schicht. Die weitere Maske umfasst grundsätzlich mindestens die zweite Schicht. Eine erste Schicht ist nicht unbedingt notwendig. Es kann eine erste Strukturierung in der weiteren Maske erzeugt werden, insbesondere durch beide Schichten hindurch und/oder durch Ätzen.

Die Schattenmaske kann zwei Schichten umfassen. Eine erste Schicht kann direkt auf dem Substrat oder auf der weiteren Maske aufliegen, also beispielsweise auf der zweiten Schicht der weiteren Maske. Die erste Schicht der Schattenmaske kann zum Beispiel SiO₂ umfassen oder daraus bestehen. Eine zweite Schicht der Schattenmaske kann auf der ersten Schicht aufliegen. Die zweite Schicht kann zum Beispiel Si₃N₄ umfassen oder daraus bestehen. Die erste Schicht kann eine Dicke von mindestens 20 nm, insbesondere mindestens 0,3 µm und/oder höchstens 5 µm, insbesondere höchstens 20 µm oder 50 µm, aufweisen. Die zweite Schicht kann eine Dicke von mindestens 100 nm, insbesondere höchstens 50 nm und/oder höchstens 5µm, insbesondere höchstens 500 nm, insbesondere etwa 200 nm aufweisen. Insbesondere ist die erste Schicht dicker als die zweite Schicht.

Es kann eine der ersten Strukturierung der weiteren Maske entsprechende zweite Strukturierung in der Schattenmaske erzeugt werden, insbesondere durch beide Schichten hindurch und/oder durch Ätzen. Die zweite Strukturierung ist dabei typischerweise versetzt gegenüber der ersten Strukturierung angeordnet und/oder dient der Herstellung derselben Struktur auf dem Substrat wie die erste Strukturierung. Es kann zudem eine dritte Strukturierung in der Schattenmaske erzeugt werden, insbesondere durch beide Schichten hindurch und/oder durch Ätzen. Die dritte Strukturierung ist insbesondere versetzt gegenüber der ersten und/oder zweiten Strukturierung angeordnet. Die dritte Strukturierung dient insbesondere der Herstellung einer weiteren, zusätzlichen Struktur auf dem Substrat. Auf diese Weise können Kontakte und/oder Elektroden hergestellt werden.

Es kann ein Ätzen der so hergestellten Strukturierung erfolgen, um Stützen herzustellen, beispielsweise mit Fluorwasserstoffsäure, beispielsweise in einer Konzentration von 1%. Diese Säure hat eine hohe Selektivität von SiO₂ zu Si₃N₄. Dadurch werden die jeweiligen zweiten Schichten aus Si₃N₄ unterätzt. Es verbleiben Stützen. Diese zuvor definierten bzw. angelegten Stützen sind dabei so groß, dass eine Oxidsäule verbleibt. Auf diese Weise kann die ansonsten freistehende Strukturierung auf ihrer Höhe und Position gehalten werden. Alternativ können beliebige andere geeignete Materialien für Stützen und/oder Schattenmaske verwendet werden, z. B. amorphes Silizium, a-Si, als Material für Stützen. In dem Fall kann etwa mit Xenondifluorid geätzt werden, ohne die Schattenmaske anzugreifen.

Es kann ein Positionieren des so vorbereiteten Substrats mitsamt der Schattenmaske und der weiteren Maske in einer Kammer zur Abscheidung, z. B. einer Molekularstrahlepitaxie-Anlage, erfolgen. Es kann eine Ausrichtung des Substrats mitsamt der Masken erfolgen, um ein erstes Quellmaterial durch die Schattenmaske hindurch zu bewegen und abzuscheiden.

In einem Ausführungsbeispiel wird ein erfindungsgemäßes Verfahren verwendet, um beispielsweise einen Nano-Hallbarren aus CrBiSbTe herzustellen. Als Substrat wird Silizium, insbesondere hochohmiges Silizium (111), oder Saphir verwendet. Es wird das oben beschriebene Verfahren verwendet, wobei die weitere Maske aus 5 nm SiO₂ und 25 nm Si₃N₄ aufgebaut wird. Die Schattenmaske wird aus 0,3 µm bis 5 µm SiO₂ und 200 nm Si₃N₄ aufgebaut. Es wird mit 1% Fluorwasserstoffsäure geätzt. Zuerst wird Bi durch die Schattenmaske hindurch abgeschieden. Es sind ferner Materialquellen für Cr, Sb und Te vorhanden. Es wird nacheinander Quellmaterial abgeschieden. Vor der Abscheidung des zweiten und jedes zusätzlichen Quellmaterials erfolgt eine Relativbewegung zur Ausrichtung der jeweiligen Materialquelle auf den Bereich. Es wird eine geeignete Abscheidungstemperatur eingestellt. So kann ein Hallbarren in-situ hergestellt werden. Anschließend kann beispielsweise eine Kontaktierung mittels Pt erfolgen, insbesondere ebenfalls in-situ. Anschließend kann beispielsweise eine Abdeckung mit Al₂O₃ erfolgen, insbesondere ebenfalls in-situ.

In einem anderen Ausführungsbeispiel wird ein oder mehrere Majorana-Materialien hergestellt und/oder es wird ein Baustein für ein Majorana-Qubit hergestellt. Es werden beispielsweise drei Nanoribbons gewachsen, insbesondere aus CrBiSbTe. Die drei Nanoribbons können T-förmig zueinander ausgerichtet hergestellt werden. Die Nanoribbons können mit einem oder mehreren Supraleitern bedeckt werden, wodurch lokalisierte Majorana Nullmoden an den jeweiligen Enden hergestellt werden, die miteinander interagieren können.

Ein Majorana-Material gemäß der vorliegenden Erfindung ist ein Material, in dem Majorana-Nullmoden entstehen, sobald man diese Materialien in Kontakt mit einem Supraleiter bringt und die zur Erzeugung der MZMs (Majorana zero modes; Majorana-Nullmoden) notwendigen Felder (E-Feld und B-Feld) anlegt. Majorana-Materialien sind beispielsweise Diracmaterialien, welche sich wiederum in beispielhaft topologische Isolatoren und Weyl-Metalle unterteilen lassen, sowie "half-metals", welche nicht zu verwechseln sind mit Halbmetallen (engl. semimetals), sowie III-V-Halbleiter Nanodrähte. Notwendigerweise besitzen Majorana-Materialien fermionische Zustände, die keinen Spin-Freiheitsgrad besitzen (in der englischen Sprache und im weiteren Verlauf dieses Dokuments werden diese Zustände als "spinless fermions" bezeichnet). In einer Teilmenge der Majorana-Materialien, den sogenannten topologischen Isolatoren (Tls), führt beispielsweise die Spin-Bahn-Wechselwirkung im Festkörper dazu, dass für fermionische Zustände an der Oberfläche des TIs die Richtung des Spins an die Bewegungsrichtung des Elektrons gekoppelt ist.

Es können auch abweichende Quellmaterialien verwendet werden. Beispielsweise kann Cr durch Mn, V oder Fe ersetzt werden. Diese Materialien sind unter den typischen praktischen Bedingungen typischerweise nicht mit selektivem Wachstum kompatibel. Diese Materialien können erfindungsgemäß gleichzeitig und/oder nacheinander abgeschieden werden. Kompatibilität mit selektivem Wachstum im Sinne der Erfindung gilt in Bezug zu den typischen praktischen Bedingungen. Die Temperatur des Substrats beträgt typischerweise mindestens -270°C, insbesondere mindestens 100 °C und/oder höchstens 3000 °C, insbesondere höchstens 500 °C.

Die Voraussetzung für selektives Wachstum besteht insbesondere darin, dass in dem Bereich, in dem Material wachsen soll, innerhalb eines Temperaturfensters das Absorptions- zu Desorptionsverhältnis der abzuscheidenden Quellmaterialien groß genug ist, um das Wachstum eines Kristalls zu ermöglichen. Während in den angrenzenden Bereichen, wo kein Wachstum stattfinden soll, das Adsorptions- zu Desorptionsverhältnis der benutzten Quellmaterialien so klein ist, dass dort kein Material auf dem Substrat oder auf der weiteren Maske abgeschieden wird, trotz nominal identischer/gleicher Temperatur des Heizelements zum Heizen des Substrats. In anderen Worten führt ein Unterschied in der anzutreffenden Oberflächenbeschaffenheit zwischen Substrat und Bereichen, an denen das Substrat durch eine Schattenmaske oder eine weitere Maske bedeckt ist dazu, dass ein Kristall auf dem Substrat wächst, nicht jedoch auf einer der genannten Masken.

Kompatibilität mit selektivem Wachstum kann auch abhängen von den anderen Quellmaterialien. Das oder die nicht im selben Temperaturfenster selektiv abscheidbare

Quellmaterial oder Quellmaterialien ist unter diesen Bedingungen dann nicht kompatibel mit selektivem Wachstum.

In einer Ausgestaltung wird nach dem Abscheiden des ersten Quellmaterials, des zweiten Quellmaterials und ggf. weiterer oder zusätzlicher Quellmaterialien die hergestellte Phase, z. B. das hergestellte Verbundmaterial, umhüllt. Insbesondere erfolgt das Umhüllen mit einer undurchlässigen Schicht. Das Umhüllen erfolgt insbesondere so, dass keine ungewünschten Stoffe, insbesondere Gase, zum Verbundmaterial gelangen können. Das Umhüllen erfolgt insbesondere, bevor das Verbundmaterial mit einem Gas, insbesondere einem nicht inerten Gas, in Kontakt kommt. Das Umhüllen erzeugt eine Passivierungsschicht.

Die undurchlässige Schicht ist insbesondere undurchlässig für Sauerstoff. Die undurchlässige Schicht ist insbesondere gasdicht. Die undurchlässige Schicht kann Siliziumnitrid oder Al₂O₃ umfassen oder daraus hergestellt sein. Die undurchlässige Schicht kann aus einer Gasphase abgeschieden worden sein. Die undurchlässige Schicht kann mit derselben Methode abgeschieden werden wie das erste und/oder zweite Quellmaterial. Die undurchlässige Schicht kann unter Rotation, insbesondere des Substrats, typischerweise um die z-Achse, aufgebracht werden. Die undurchlässige Schicht kann aufgetragen werden, während ein abgeschiedenes Material und/oder Verbundmaterial von der weiteren Maske, des Substrats und/oder einem weiteren abgeschiedenen Material und/oder Verbundmaterial begrenzt ist. Die undurchlässige Schicht ist insbesondere dünn. Beispielsweise beträgt die Dicke der undurchlässigen Schicht weniger als 50 nm, bevorzugt weniger als 10 nm, insbesondere mindestens 3 nm. Die undurchlässige Schicht verhindert einen Alterungsprozess des Verbundmaterials, auch als "Aging" bezeichnet, bei dem Fremdatome sich in das Verbundmaterial einlagern.

In einer Ausgestaltung wird ferner eine Abschirmungsstruktur verwendet, um einen Teil des Bereichs abzuschirmen, so dass kein Quellmaterial auf dem Teil des Bereichs abgeschieden wird. Die Abschirmungsstruktur ist separat von der Maske und der Schattenmaske. Die Abschirmungsstruktur kann beispielsweise beim Herstellen von Funktionalmaterial, etwa für Elektroden bzw. Kontakte verwendet werden, um auf dem Teil des Bereichs das entsprechende Material gezielt nicht abzuscheiden. So kann etwa eine Trennung der Elektroden bzw. Kontakte erzeugt werden.

Ein weiterer Aspekt der Erfindung ist eine Vorrichtung zur Herstellung einer Struktur durch Abscheidung von Quellmaterial auf einem Substrat . Die Vorrichtung umfasst eine Haltevorrichtung zum Halten eines Substrats und eine erste Materialquelle zur Freisetzung eines abzuscheidenden ersten Quellmaterials, wobei die erste Materialquelle in einer Abscheidungsposition relativ zu dem mittels der Haltevorrichtung gehaltenen Substrat angeordnet werden kann. Die Vorrichtung umfasst ferner eine Schattenmaske zur Begrenzung mindestens eines Bereichs, an dem Quellmaterial abgeschieden wird. Alle Merkmale, Vorteile und Eigenschaften des eingangs beschriebenen Verfahren können ebenso für die Vorrichtung gelten und umgekehrt.

In einer Ausgestaltung umfasst die Vorrichtung ferner eine zweite Materialquelle zur Freisetzung eines abzuscheidenden zweiten Quellmaterials, und insbesondere eine Bewegungseinrichtung zur Durchführung einer Relativbewegung zwischen der ersten Materialquelle und/oder der zweiten Materialquelle einerseits und dem mittels der Haltevorrichtung gehaltenen Substrat andererseits. Diese ist insbesondere derart, dass die zweite Materialquelle in einer Abscheidungsposition relativ zum Substrat angeordnet wird.

Insbesondere umfasst die Vorrichtung ferner entsprechende Einrichtungen zur Durchführung weiterer beschriebener Verfahrensschritte und -merkmale. Die Vorrichtung kann eine dritte Materialquelle und optional eine vierte Materialquelle umfassen. Die Vorrichtung kann entsprechende Bewegungseinrichtungen für die dritte und ggf. vierte Bewegungseinrichtung aufweisen. Es können eine oder mehrere Bewegungseinrichtungen für sämtliche Bewegungen vorgesehen sein. Es kann eine Einrichtung zur Einstellung einer gewünschten Temperatur vorhanden sein, beispielsweise für eine Temperaturerhöhung. Es kann eine weitere Materialquelle und/oder eine weitere Maske vorhanden sein.

Durch Verwendung der Schattenmaske in Kombination mit der weiteren Maske können auch Quellmaterialien, die mittels der weiteren Maske nicht abgeschieden werden können, wie z. B. (magnetische) Übergangsmetalle, wie beschrieben selektiv abgeschieden werden.

Ein weiterer Aspekt der Erfindung ist eine Struktur, insbesondere eine Mikro- oder Nanostruktur, die mit dem erfindungsgemäßen Verfahren herstellbar oder hergestellt sein kann. Insbesondere umfasst die Struktur ein Verbundmaterial. In einer Ausgestaltung umfasst die Struktur eine erste Phase, die mindestens ein erstes Quellmaterial umfasst. Insbesondere ist das erste Quellmaterial nicht kompatibel mit selektivem Wachstum, insbesondere nicht kompatibel mit einem herkömmlichen selektiven Wachstum, welches ohne eine Schattenmaske gemäß der vorliegenden Erfindung auskommt. Insbesondere ist das erste Quellmaterial unter Verwendung einer Schattenmaske hergestellt worden. In einer Ausgestaltung umfasst die Struktur eine zweite Phase, die ein zweites Quellmaterial und insbesondere ferner ein drittes Quellmaterial, ggf. ein viertes Quellmaterial, beispielsweise ein fünftes Quellmaterial und optional ein oder mehrere zusätzliche Quellmaterialien umfasst. Das erste Quellmaterial umfasst insbesondere Cr, Fe, Mn und/oder V. Alle Merkmale, Vorteile und Eigenschaften des eingangs beschriebenen Verfahrens sowie der Vorrichtung können ebenso für die Struktur gelten und umgekehrt.

In einer Ausführungsform ist die Grenzfläche zwischen der ersten Phase und der zweiten Phase kontaminationsfrei. Mit anderen Worten befinden sich dort keinerlei Verunreinigungen. Dann weist die an die Grenzfläche angrenzende erste Phase keine Verunreinigungen auf und die an die Grenzfläche angrenzende zweite Phase weist keine Verunreinigungen auf. Bevorzugt befinden sich dort keine Sauerstoffatome, keine anderen Atome von Gasen und/oder überhaupt keine Fremdatome. Dies wird erst durch das erfindungsgemäße Verfahren möglich, da durch die Herstellung unmittelbar hintereinander keinerlei Kontakt mit anderen Stoffen erfolgt. Bevorzugt ist die Grenzfläche epitaktisch. Unter einem epitaktischen Aufwachsen wird insbesondere verstanden, dass auf einer kristallinen Phase eine weitere kristalline Phase abgeschieden wird, wobei mindestens eine kristallographische Orientierung der abgeschiedenen weiteren kristallinen Phase einer Orientierung der kristallinen Schicht der kristallinen Phase entspricht. Also entspricht insbesondere mindestens eine kristallographische Orientierung der zweiten Phase einer Orientierung der ersten Phase. Insbesondere ist die erste Phase an der Grenzfläche kristallin und/oder die zweite Phase ist an der Grenzfläche kristallin. Es liegt damit eine geordnete Gitterstruktur vor.

Eine Phase meint ein zusammenhängendes, insbesondere homogenes Volumen eines Materials, beispielsweise eines Verbundmaterials oder eines Quellmaterials, insbesondere in kristalliner Form.

Die Struktur ist insbesondere eine Hybridstruktur. Die Struktur kann wenigstens ein strukturiertes Majorana-Material und insbesondere wenigstens ein darauf angeordnetes supraleitendes Material umfassen. Erfindungsgemäß kann die Herstellung auch andersherum erfolgen. So kann zunächst ein supraleitendes Material hergestellt werden, insbesondere durch selektive Abscheidung durch die Schattenmaske, bevorzugt selektives Wachstum, und anschließend ein Majorana-Material darauf gewachsen werden. Die Struktur kann eine Passivierungsschicht umfassen. Insbesondere weist die Struktur, typischerweise das strukturierte Majorana-Material eine drahtförmige Ausgestaltung auf, und/oder eine Ausgestaltung mit einer Länge von mindestens 0,1 und/oder höchstens 100 µm, einer Breite von mindestens 10 und/oder höchstens 200 nm und/oder einer Schichtdicke von mindestens 0,2 nm, vorzugsweise mindestens 5 nm und/oder höchstens 260 nm, vorzugsweise höchstens 50 nm, auf. Insbesondere ist eine Grenzfläche zwischen dem strukturierten Majorana-Material und wenigstens einem daran angeordneten supraleitenden Material kontaminationsfrei. Daran angeordnet meint darauf, darunter, daneben, etc., bei einem direkten Kontakt zwischen den zwei Materialien. Insbesondere ist die Oberfläche des strukturierten Majorana-Materials vollständig abgedeckt ist, und zwar durch ein Material, welches eine native Oxidationsschicht auszubilden vermag, ein supraleitendes Material und/oder eine Passivierungsschicht.

In einer Ausgestaltung ist die Struktur vollständig umhüllt, insbesondere mit einer undurchlässigen Schicht, einem Substrat und/oder einer weiteren Maske. Eine erste Seite, die während des Abscheidens oben liegen kann, kann vom Substrat bedeckt sein. Das Substrat ist insbesondere undurchlässig. Seitliche Flächen, insbesondere alle umlaufenden seitlichen Flächen, kann zumindest teilweise von der weiteren Maske bedeckt sein. Dies ist jedoch nicht unbedingt erforderlich. Die weitere Maske kann zumindest teilweise und/oder bereichsweise undurchlässig sein. Alle weiteren Oberflächen der ersten Phase und der zweiten Phase und ggf. jeder weiteren Phase, falls vorhanden, können von einer undurchlässigen Schicht bedeckt sein. Die undurchlässige Schicht entspricht insbesondere der oben beschriebenen Umhüllung. Insbesondere ist die Struktur vollständig gekapselt, so dass keine ungewünschten Stoffe, insbesondere Gase, zu den jeweiligen Phasen gelangen können.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben ist. Die beanspruchten Schutzbereiche sind nicht auf die Ausführungsbeispiele beschränkt.

Es zeigen:
- Figur 1:: ein herkömmliches Verfahren zur Herstellung einer Nanostruktur,
- Figuren 2 bis 6:: Schritte eines erfindungsgemäßen Verfahrens zur Herstellung einer Nanostruktur,
- Figuren 7 bis 9:: Schritte zur Herstellung einer Maske, sowie
- Figuren 10 bis 11:: schematische Darstellungen unterschiedlicher erfindungsgemäßer Verfahren.

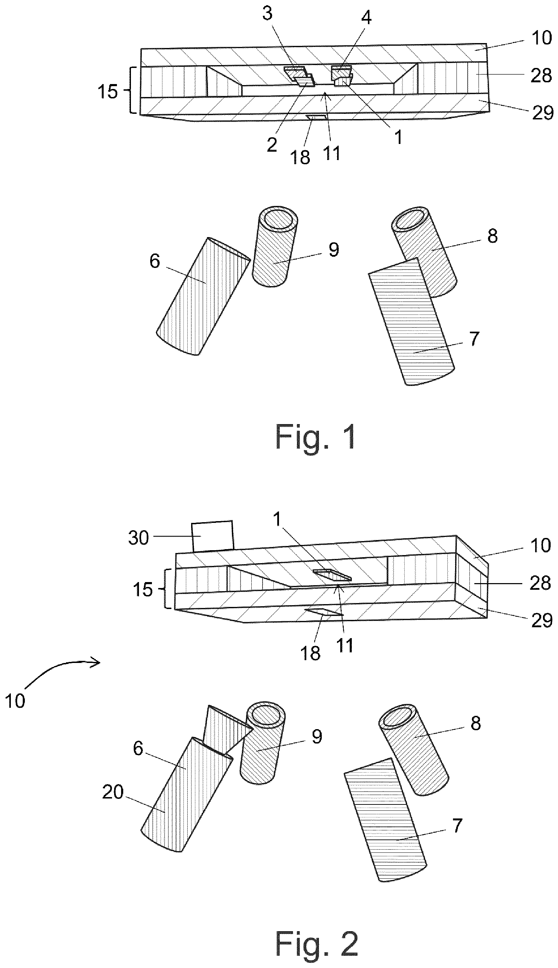

Figur 1 zeigt die Co-Evaporation mehrerer Quellmaterialien 1, 2, 3, 4 durch eine Schattenmaske 15. Es ist ein Substrat 10 mit einer Schattenmaske 15 dargestellt. Die Schattenmaske besteht aus einer ersten Schicht, die als Abstandhalter dienende Säulen definiert, sowie aus einer von den Säulen in einem Abstand zum Substrat gehaltenen zweiten Schicht mit einer Öffnung 18. Die Öffnung 18 hat vier Begrenzungen, nämlich Kanten des die Aussparung ausbildenden Materials. Es sind vier verschiedene Materialquellen 6, 7, 8, 9 vorhanden, die jeweils ein Quellmaterial 1, 2, 3, 4 abgeben, damit dieses durch die Öffnung 18 auf einen Bereich 11 des Substrats 10 transportiert werden kann. Das jeweilige Quellmaterial 1, 2, 3, 4 lagert sich dann dort an. Es ist ersichtlich, dass die unterschiedlichen Positionen der einzelnen Materialquellen 6, 7, 8, 9 dazu führen, dass das jeweilige Quellmaterial 1, 2, 3, 4 an unterschiedlichen Teilen des Bereichs 11 abgelagert wird. Es kann also keine scharf abgegrenzte Struktur hergestellt werden. Für diesen Effekt ist es unerheblich, ob eine gleichzeitige oder sukzessive Abscheidung erfolgt.

Figur 2 zeigt eine ähnliche Darstellung zur Durchführung des erfindungsgemäßen Verfahrens. Zur Vermeidung von Dopplungen wird auf Wiederholungen verzichtet und stattdessen auf die obere Beschreibung der Figur 1 verwiesen. Hier wird insbesondere auf die Unterschiede zur Figur 1 eingegangen. Es ist eine rein schematisch dargestellte Haltevorrichtung 30 vorhanden, mit der das Substrat, insbesondere mitsamt der Schattenmaske 15, gehalten werden kann.

Die erste Materialquelle 6 befindet sich in der Abscheidungsposition 20. Die zweite Materialquelle 7, die dritte Materialquelle 8 und die vierte Materialquelle 9 befinden sich jeweils nicht in der Abscheidungsposition 20. Es wird mittels der ersten Materialquelle 6 ein erstes Quellmaterial 1 durch die Öffnung 18 in der Schattenmaske 15, insbesondere in deren zweiter Schicht 29, bewegt und auf dem Substrat 10 abgeschieden. Es ist sichtbar, dass eine dünne Lage des ersten Quellmaterials 1 auf dem Bereich 11 des Substrats 10 abgeschieden worden ist. Es kann sich um eine Monolage handeln. Der Bereich ist hier aufgrund der exemplarisch dargestellten, einzelnen, rechteckigen Öffnung 18 ebenfalls rechteckig. Durch geeignete Gestaltung der Schattenmaske 15 können allerdings beliebig komplizierte zweidimensionale Strukturen bzw. Muster erzeugt werden.

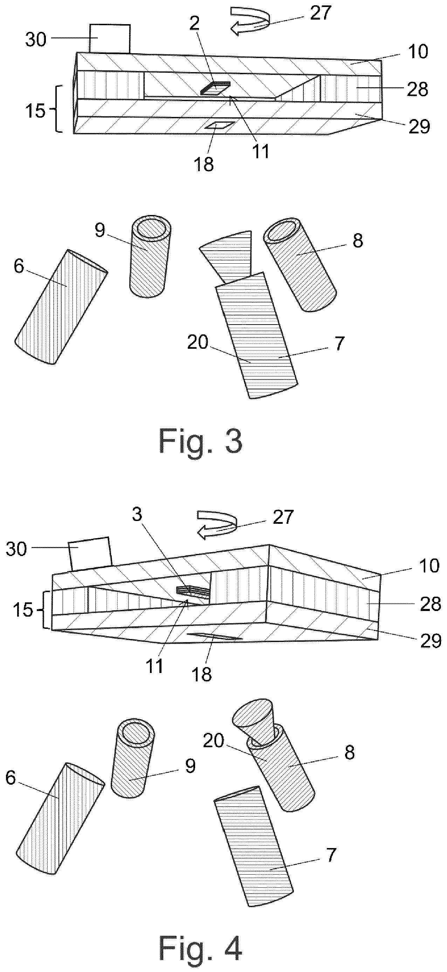

Um nun eine Schicht des zweiten Quellmaterials auf den Bereich 11 und damit exakt auf das erste Quellmaterial 1 abscheiden zu können, wird eine Relativbewegung 27 zwischen der zweiten Materialquelle 7 und dem Substrat 10 durchgeführt, beispielsweise eine relative Drehung, wie in Figur 3 mit einem Pfeil angedeutet. Beispielsweise wird das Substrat 10 mit der Schattenmaske 15 gedreht, z. B. mittels der Haltevorrichtung 30. Alternativ oder ergänzend kann die zweite Materialquelle 7 gedreht werden, beispielsweise gemeinsam mit den anderen Materialquellen 6, 8, 9. Wenn die Materialquellen 6, 7, 8, 9 auf einem Kreis oder Kreisbogen angeordnet sind, kann eine Drehung um den Mittelpunkt des Kreises oder Kreisbogens erfolgen, um mit mehreren Stufen in nur einer Drehrichtung jede beliebige Materialquelle 6, 7, 8, 9 auf den Bereich 11 am Substrat 10 ausrichten zu können.

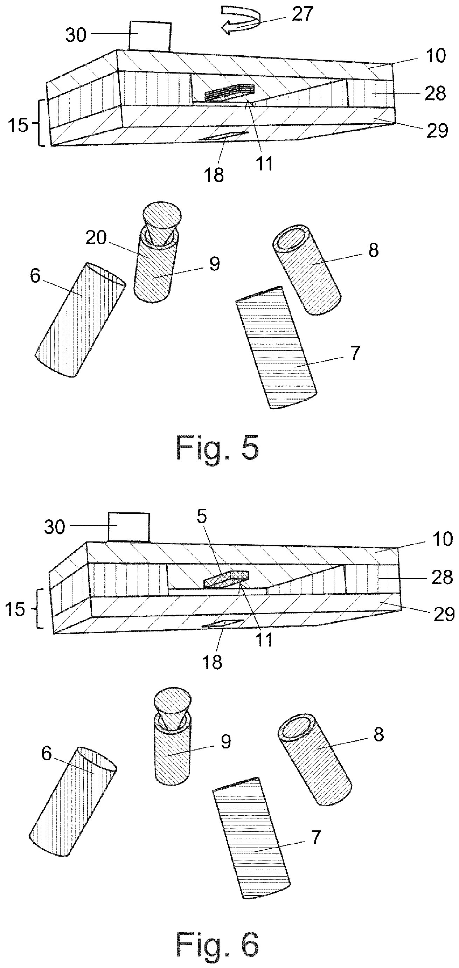

In Figur 3 ist nun die zweite Materialquelle 7 in der Abscheidungsposition 20 angeordnet. Das zweite Quellmaterial 2 wird auf dem zuvor abgeschiedenen ersten Quellmaterial abgeschieden. In Figur 4 befindet sich, nach einer erneuten Relativbewegung 27, die dritte Materialquelle 8 in der Abscheidungsposition 20. Das dritte Quellmaterial 3 wird auf dem zuvor abgeschiedenen zweiten Quellmaterial abgeschieden. In Figur 5 befindet sich, nach einer erneuten Relativbewegung 27, die vierte Materialquelle 9 in der Abscheidungsposition 20. Das vierte Quellmaterial wird auf dem zuvor abgeschiedenen dritten Quellmaterial abgeschieden. Insbesondere werden gleichartige Schichten der Quellmaterialien, also beispielsweise mit gleichen Schichtdicken, abgeschieden. Die dritten und vierten Materialquellen 8, 9 sowie die Abscheidung des dritten Quellmaterials 3 und des vierten Quellmaterials 4 sind rein optional. Je nach den benötigten Komponenten für die herzustellende Nanostruktur kann eine jeweils benötigte Anzahl an Materialquellen gewählt werden, beispielsweise auch fünf, sechs, sieben oder acht Materialquellen und eine entsprechende Anzahl an insbesondere unterschiedlichen Quellmaterialien.

Figur 6 zeigt den optionalen Schritt des Erhitzens der abgeschiedenen Quellmaterialien, insbesondere durch Erhitzen eines Heizelements in der Nähe des Substrats, z. B. in oder an der Kammer, in der sich das Substrat befindet. Auf diese Weise wird aus der Schichtfolge der vier Quellmaterialien 1, 2, 3, 4 ein Verbundmaterial 5 gebildet.

In einem Ausführungsbeispiel können die vier Quellmaterialien Bi, Cr, Sb und Te sein. Die Abscheidung von Bi, Cr und Sb kann jeweils bei ca. 100 °C erfolgen. Anschließend kann insbesondere zeitgleich ein Erhitzen auf ca. 200°C sowie die Abscheidung von Te erfolgen, wodurch ein Verbundmaterial erzeugt wird, nämlich ein BiCrSbTe-Kristall, beispielsweise mit einer Kristallstruktur ähnlich dem Tetradymit.

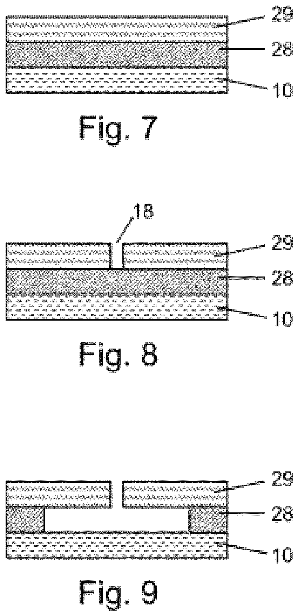

Die Figuren 7 bis 9 zeigen in Schnittzeichnungen Schritte zur Herstellung einer Maske auf einem Substrat 10. Die Maske kann eine Schattenmaske oder eine weitere Maske sein. Die Schichtdicken sind nicht maßstabsagetreu, es handelt sich vielmehr um rein schematische Darstellungen.

In Figur 7 ist auf einer durchgehenden Substratschicht, beispielsweise aus Saphir oder Silizium, z. b. Si(111), eine durchgehende erste Schicht 28 ausgebildet, beispielsweise aus SiO₂. Die erste Schicht kann eine Dicke zwischen 500 nm und 1000 nm aufweisen, z. B. ungefähr 750 nm. Auf der ersten Schicht 28 ist eine durchgehende zweite Schicht 29 ausgebildet, beispielsweise aus Si₃N₄. Die zweite Schicht kann eine Dicke zwischen 100 nm und 200 nm aufweisen, beispielsweise ungefähr 120 nm.

Es werden die gewünschten Strukturen in die zweite Schicht 29 eingebracht, beispielsweise durch Ätzen. Figur 8 zeigt rein beispielhaft eine Öffnung 18 in der zweiten Schicht. Anschließend wird ein freistehender Teil der Maske freigelegt durch Entfernung dazwischenliegender Bereiche der ersten Schicht 28, hier des SiO₂, z. B. durch Ätzen mit Fluorwasserstoffsäure. Es verbleiben Säulen, hier aus SiO₂, die die zweite Schicht 29 am Substrat 10 halten, wie in Figur 8 dargestellt.

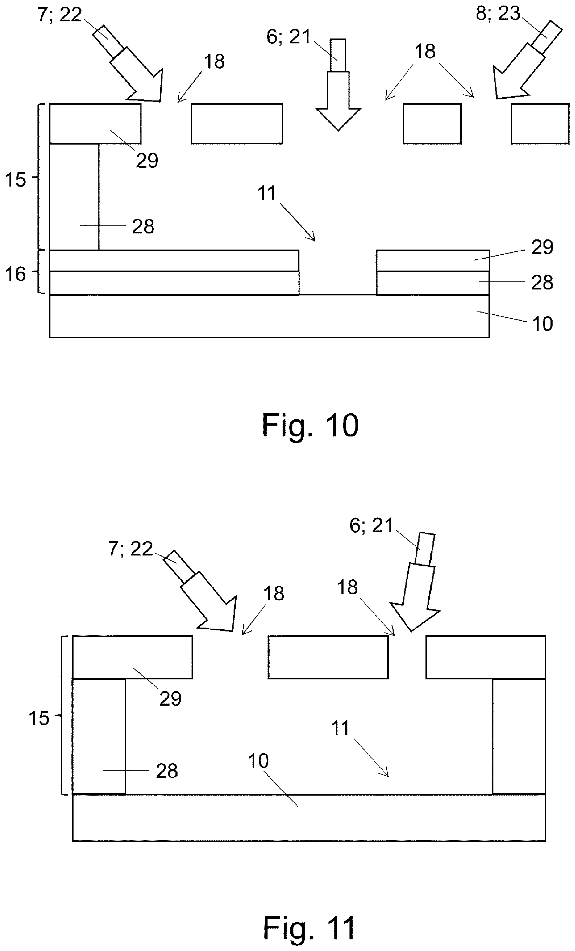

Figur 10 zeigt ein weiteres Verfahren zur Herstellung einer Nanostruktur. Aspekte des hier gezeigten Verfahrens können beliebig mit dem Verfahren gemäß dem beigefügten Anspruch 1 und/oder dem in den Figuren 2 bis 6 gezeigten Verfahren kombiniert werden. Es sind eine erste Materialquelle 6 und eine zweite Materialquelle 7 vorhanden.

Auf dem Substrat ist eine weitere Maske 16 vorhanden. Diese umfasst zwei Schichten 28, 29, die beispielsweise analog zu den zwei Schichten 28, 29 der Schattenmaske aus Figur 9 aufgebaut sein kann. Es ist beispielhaft eine Öffnung 18 in der weiteren Maske 16 vorhanden, durch die der Bereich 11 des Substrats 10, auf dem Quellmaterial abgeschieden werden soll, freiliegt.

Auf der weiteren Maske 16 ist eine Schattenmaske 15 vorhanden. Diese umfasst zwei Schichten 28, 29, die beispielsweise analog zu den zwei Schichten 28, 29 der Schattenmaske aus Figur 9 aufgebaut sein kann. Die Schichtdicken sind insbesondere größer als bei der weiteren Maske 16. Die erste Schicht 28 kann beispielsweise aus Stützen oder Säulen bestehen. Es sind beispielhaft drei Öffnungen 18 in der Schattenmaske 16 vorhanden, um Quellmaterial passieren zu lassen.

Die erste Materialquelle 6 befindet sich in einer ersten Position 21, beispielsweise senkrecht über dem Bereich 11. Das erste Quellmaterial kann so in der mit dem Pfeil angezeigten Richtung senkrecht zur Oberfläche des Substrats 10 zum Bereich 11 bewegt werden, und zwar durch die Öffnung 18 in der Schattenmaske 15 sowie durch die Öffnung 18 in der weiteren Maske 16. Auf diese Weise kann beispielsweise ein Quellmaterial abgeschieden werden, welches durch Einstellen einer definierten Temperatur selektiv auf dem Substrat, nicht jedoch auf der weiteren Maske 16 abgeschieden werden kann, wie es beispielsweise aus der Publikation WO 2018 171 823 A1 bekannt ist.

Eine der Öffnung 18 der weiteren Maske 16 entsprechende Öffnung ist auf der links dargestellten Seite in der Schattenmaske 15 angeordnet. Die zweite Materialquelle 22 befindet sich auf der zweiten Position 22. Zweites Quellmaterial kann somit entlang der mit dem Pfeil angezeigten, hier beispielhaft schräg nach rechts weisenden Richtung durch diese entsprechende Öffnung 18 in der Schattenmaske zum Bereich 11 bewegt werden und beispielsweise gleichzeitig mit dem ersten Quellmaterial dort abgeschieden werden. Das zweite Quellmaterial kann beispielsweise ein Quellmaterial sein, welches nicht dazu geeignet ist, auf bekannte Weise bei einer definierten Temperatur selektiv auf dem Substrat abgeschieden zu werden. Die Schattenmaske 15 ermöglicht ein Aufbringen von Quellmaterial lediglich an den Aussparungen oder Öffnungen.

Optional ist eine dritte Materialquelle 8 vorhanden, mit der ein zusätzliches oder weiteres Quellmaterial abgeschieden werden kann. Die dritte Materialquelle 23 befindet sich auf einer rechts gezeigten dritten Position 23. Ein zusätzliches oder weiteres Quellmaterial kann somit entlang der mit dem Pfeil angezeigten, hier beispielhaft schräg nach links zeigenden Richtung durch diese entsprechende Öffnung 18 in der Schattenmaske zum Bereich 11 bewegt werden und beispielsweise gleichzeitig mit dem ersten und/oder zweiten Quellmaterial dort abgeschieden werden. Alternativ oder ergänzend kann das zusätzliche oder weitere Quellmaterial z. B. nach der Abscheidung des ersten und/oder zweiten Quellmaterials abgeschieden werden. Das zusätzliche oder weitere Quellmaterial kann ein Quellmaterial sein, welches nicht dazu geeignet ist, auf bekannte Weise bei einer definierten Temperatur selektiv auf dem Substrat abgeschieden zu werden. Die Schattenmaske 15 ermöglicht auch in diesem Fall ein Aufbringen von Quellmaterial lediglich an den Aussparungen oder Öffnungen. Es kann aber auch ein zur derartigen selektiven Abscheidung geeignetes Quellmaterial verwendet werden.

Aus einer oder mehreren ersten Materialquellen 6 können beispielsweise Bi, Sb und Te zur Abscheidung freigesetzt werden. Diese Quellmaterialien können unter Verwendung der weiteren Maske 16 selektiv gewachsen werden. Aus der zweiten Materialquelle 2 kann beispielsweise Cr zur Abscheidung freigesetzt werden. Cr-Atome können durch die Schattenmaske 16 blockiert werden, so dass sie selektiv nur an dem Bereich 11 auftreffen. Aus der dritten Materialquelle 3 kann beispielsweise ein Metall und/oder ein Supraleiter zur Abscheidung freigesetzt werden.

Als zweite Materialquelle 6 kann eine Materialquelle zur Abgabe eines oder mehrerer Quellmaterialien dienen. Als zweite Materialquelle 6 kann beispielsweise eine Vorrichtung mit mehreren Materialquellen vorgesehen sein, die in einem Kreisbogen oder Kreis angeordnet sind. Es können dann nacheinander unterschiedliche Materialquellen verwendet werden, um unterschiedliche Quellmaterialien nacheinander abzuscheiden. Davor, zeitgleich und/oder danach können durch die Materialquellen 7 und ggf. 8 ein oder mehrere Quellmaterialien abgeschieden werden. So können die beschriebenen Verfahren kombiniert werden.

Figur 11 zeigt ein anderes erfindungsgemäßes Verfahren. Aspekte des hier gezeigten Verfahrens können beliebig mit dem Verfahren gemäß dem beigefügten Anspruch 1 und/oder dem in den Figuren 2 bis 6 gezeigten Verfahren kombiniert werden. Hierbei ist auf dem Substrat lediglich eine Schattenmaske 15 erzeugt worden. Diese umfasst zwei Schichten 28, 29, die beispielsweise analog zu den zwei Schichten 28, 29 der Schattenmaske aus Figur 9 aufgebaut sein kann. Die erste Schicht 28 ist typischerweise säulenförmig aufgebaut. Der säulenförmige Aufbau hat den Vorteil, dass ein ausreichender Abstand von der Oberfläche des Substrats 10 bis zur zweiten Schicht 29 besteht, um die Abscheidung aus unterschiedlichen Positionen 21, 22 zu ermöglichen. Auch hier sind beispielhaft zwei Öffnungen 18 in der Schattenmaske 16 vorhanden, um Quellmaterial passieren zu lassen. Es ist in diesem Beispiel keine weitere Maske vorhanden.

Die erste Materialquelle 6 befindet sich in einer ersten Position, die sich nicht genau senkrecht, sondern etwas schräg über dem Bereich 11 des Substrats 10 befindet, an dem abgeschieden werden soll. Die zweite Materialquelle 7 befindet sich ähnlich wie in Figur 10 auf der linken Seite. Beispielsweise können am Ort der zweiten Materialquelle 7 mehrere Materialquellen befinden, die beispielsweise Cr, Bi, Sb und Te nacheinander abscheiden. Dies kann mit der Technik gemäß den Figuren 2 bis 6 realisiert sein. Beispielsweise kann die erste Materialquelle 6 zur Freisetzung eines Metalls oder Supraleiters eingerichtet sein. So kann auf besonders einfache Weise und ohne Herstellung einer selektiv wirkenden weiteren Maske beispielsweise eine Nanostruktur in Form eines oder mehrerer CrBiSbTe-Kristalle hergestellt werden.

### Bezugszeichenliste

| | |
|---|---|
| Erstes Quellmaterial | 1 |
| Zweites Quellmaterial | 2 |
| Drittes Quellmaterial | 3 |
| Viertes Quellmaterial | 4 |
| Verbundmaterial | 5 |
| Erste Materialquelle | 6 |
| Zweite Materialquelle | 7 |
| Dritte Materialquelle | 8 |
| Vierte Materialquelle | 9 |
| Substrat | 10 |
| Bereich | 11 |
| Schattenmaske | 15 |
| Weitere Maske | 16 |
| Öffnung | 18 |
| Abscheidungsposition | 20 |
| Erste Position | 21 |
| Zweite Position | 22 |
| Dritte Position | 23 |
| Relativbewegung | 27 |
| Erste Schicht | 28 |
| Zweite Schicht | 29 |
| Haltevorrichtung | 30 |

## Patentansprüche

1. Verfahren zur Herstellung einer Struktur durch Abscheidung von Quellmaterial (1, 2, 3, 4) auf einem Substrat (10), wobei eine Schattenmaske (15) verwendet wird, um mindestens einen Bereich (11) zu begrenzen, an dem Quellmaterial (1, 2, 3, 4) abgeschieden wird, mit den Schritten:
- Abscheiden eines ersten Quellmaterials (1) mittels einer ersten Materialquelle (6), wobei die erste Materialquelle (6) in einer Abscheidungsposition (20) relativ zum Substrat (10) angeordnet ist,
- Durchführen einer Relativbewegung (27) zwischen der ersten Materialquelle (6) und/oder einer zweiten Materialquelle (7) einerseits und dem Substrat (10) andererseits derart, dass die zweite Materialquelle (7) in einer Abscheidungsposition (20) relativ zum Substrat (10) angeordnet wird,
- Abscheiden eines zweiten Quellmaterials (2) mittels der zweiten Materialquelle (7) auf dem abgeschiedenen ersten Quellmaterial (1), und
- Bilden einer Kristallstruktur, welche zumindest einen Teil des abgeschiedenen ersten Quellmaterials (1) und/oder zumindest einen Teil des abgeschiedenen zweiten Quellmaterials (2) umfasst, oder
- Bilden einer Struktur, welche zumindest einen Teil des abgeschiedenen ersten Quellmaterials (1) und zumindest einen Teil des abgeschiedenen zweiten Quellmaterials (2) umfasst.

2. Verfahren nach dem vorhergehenden Anspruch, wobei eine magnetische Phase oder ein magnetisches Verbundmaterial hergestellt wird, insbesondere ein magnetischer topologischer Isolator.

3. Verfahren nach einem der vorhergehenden Ansprüche, ferner umfassend:
- Durchführen einer Relativbewegung (27) zwischen der zweiten Materialquelle (7) und/oder einer dritten Materialquelle (8) einerseits und dem Substrat (10) andererseits derart, dass die dritte Materialquelle (8) an einer Abscheidungsposition (20) relativ zum Substrat (10) angeordnet wird,
- Abscheiden eines dritten Quellmaterials (3) mittels der dritten Materialquelle (8) auf dem abgeschiedenen zweiten Quellmaterial (2) oder einem hergestellten Verbundmaterial,

4. Verfahren nach einem der vorhergehenden Ansprüche, ferner umfassend:
- Durchführen einer Relativbewegung (27) zwischen der dritten Materialquelle (8) und/oder einer vierten Materialquelle (9) einerseits und dem Substrat (10) andererseits derart, dass die vierte Materialquelle (9) an einer Abscheidungsposition (20) relativ zum Substrat (10) angeordnet wird,
- Abscheiden eines vierten Quellmaterials (4) mittels der vierten Materialquelle (9) auf dem abgeschiedenen dritten Quellmaterial (3) oder einem hergestellten Verbundmaterial.

5. Verfahren nach einem der vorhergehenden Ansprüche, wobei nach Abscheidung der Quellmaterialien (1, 2, 3, 4) die Temperatur der abgeschiedenen Materialien (1, 2, 3, 4) erhöht wird, so dass ein Verbundmaterial (5) oder ein Kristall, entstehen kann.

6. Verfahren nach einem der vorhergehenden Ansprüche, wobei nach der Abscheidung ein zusätzliches Quellmaterial unter Verwendung der Schattenmaske (15) abgeschieden wird.

7. Verfahren nach einem der vorhergehenden Ansprüche, wobei die Materialquellen (6, 7, 8, 9) in einem Kreisbogen oder Kreis angeordnet sind.

8. Verfahren nach einem der vorhergehenden Ansprüche, wobei zumindest eine Materialquelle (6, 7, 8, 9) nicht mit anderen Materialquellen (6, 7, 8, 9) auf einem gemeinsamen Kreisbogen oder Kreis angeordnet sind, wobei für die zumindest eine Materialquelle (6, 7, 8, 9) eine weitere Schattenmaske verwendet wird, welche die zumindest eine Materialquelle (6, 7, 8, 9) auf dieselbe Stelle abbildet, auf welche die erste Schattenmaske die erste Materialquelle (6) abbildet.

9. Verfahren nach einem der vorhergehenden Ansprüche, wobei ferner eine weitere Maske (16) verwendet wird, um mindestens den Bereich (11) zu begrenzen, an dem Quellmaterial (1, 2) abgeschieden wird, das Verfahren ferner umfassend:
- Bewegen eines weiteren Quellmaterials (3, 4) mittels einer weiteren Materialquelle (8, 9) zu dem Bereich (11) unter Verwendung der weiteren Maske (16) und Abscheiden des weiteren Quellmaterials (3, 4) in dem Bereich (11), wobei die weitere Materialquelle (8, 9) in einer von der Abscheidungsposition (20) abweichenden zweiten Position (22) relativ zum Substrat (10) angeordnet sein kann.

10. Verfahren nach einem der vorhergehenden Ansprüche, **dadurch gekennzeichnet, dass** nach dem Abscheiden des ersten Quellmaterials (1), des zweiten Quellmaterials (2) und ggf. weiterer oder zusätzlicher Quellmaterialien (3, 4) die hergestellte Phase mit einer undurchlässigen Schicht umhüllt wird.

11. Verfahren nach einem der vorhergehenden Ansprüche, wobei ferner eine Abschirmungsstruktur verwendet wird, um einen Teil des Bereichs (11) abzuschirmen, so dass kein Quellmaterial auf dem Teil des Bereichs (11) abgeschieden wird.

12. Vorrichtung zur Herstellung einer Struktur durch Abscheidung von Quellmaterial (1, 2, 3, 4) auf einem Substrat (10), umfassend
- eine Haltevorrichtung (30) zum Halten eines Substrats (10),
- eine erste Materialquelle (6) zur Freisetzung eines abzuscheidenden ersten Quellmaterials (1), wobei die erste Materialquelle (6) in einer Abscheidungsposition (20) relativ zu dem mittels der Haltevorrichtung (30) gehaltenen Substrat (10) angeordnet werden kann,
- eine Schattenmaske (15) zur Begrenzung mindestens eines Bereichs (11), an welchem Quellmaterial (1, 2, 3, 4) abgeschieden wird.

13. Vorrichtung nach dem vorhergehenden Anspruch, ferner umfassend:
- eine zweite Materialquelle (7) zur Freisetzung eines abzuscheidenden zweiten Quellmaterials (2), sowie
- eine Bewegungseinrichtung zur Durchführung einer Relativbewegung (27) zwischen der ersten Materialquelle (6) und/oder der zweiten Materialquelle (7) einerseits und dem mittels der Haltevorrichtung (30) gehaltenen Substrat (10) andererseits derart, dass die zweite Materialquelle (7) in einer Abscheidungsposition (20) relativ zum Substrat (10) angeordnet wird.

14. Struktur, insbesondere Mikro- oder Nanostruktur, herstellbar nach einem Verfahren gemäß einem der vorhergehenden Ansprüche, umfassend eine erste Phase, die mindestens ein erstes Quellmaterial umfasst, und eine zweite Phase, die mindestens ein zweites Quellmaterial umfasst, wobei eine Grenzfläche zwischen der ersten Phase und der zweiten Phase kontaminationsfrei ist, wobei das erste Quellmaterial nicht kompatibel mit selektivem Wachstum ist.

15. Struktur nach dem vorhergehenden Anspruch, wobei die Struktur vollständig umhüllt ist, insbesondere mit einer undurchlässigen Schicht, einem Substrat und/oder einer weiteren Maske (16).
